(19) Europäisches Patentamt
European Patent Office
Office européen des brevets

(11) EP 0 921 579 A2

(12) EUROPEAN PATENT APPLICATION

(43) Date of publication:
09.06.1999 Bulletin 1999/23

(51) Int. Cl.[6]: **H01L 51/20**, H01L 51/30

(21) Application number: 98309580.3

(22) Date of filing: 24.11.1998

(84) Designated Contracting States:
AT BE CH CY DE DK ES FI FR GB GR IE IT LI LU MC NL PT SE
Designated Extension States:
AL LT LV MK RO SI

(30) Priority: 24.11.1997 US 976649

(71) Applicant:
LUCENT TECHNOLOGIES INC.
Murray Hill, New Jersey 07974-0636 (US)

(72) Inventor: Bao, Zhenan
North Plainfield, New Jersey 07060 (US)

(74) Representative:
Buckley, Christopher Simon Thirsk et al
Lucent Technologies (UK) Ltd,
5 Mornington Road
Woodford Green, Essex IG8 0TU (GB)

# (54) Thin film transistor based on substituted phthalocyanines

(57) Thin film, n-channel transistors in which the active layer is an ordered film of a substituted phthalocyanine coordination compound with a field-effect mobility greater than $10^{-3}$ $cm^2/Vs$ and a conductivity in the range of about $10^{-9}$ S/cm to about $10^{-7}$ S/cm at 20°C are disclosed. Examples of suitable substituted phthalocyanines include copper phthalocyanine, zinc phthalocyanine, hydrogen phthalocyanine, and tin phthalocyanine in which the phthalocyanine has at least one fluorine or chlorine substituent on at least one of its six-membered rings. Thin film devices made of these materials have an on/off ratio of at least about $10^3$. It is advantageous if the device is fabricated using a process in which the substrate is heated to a temperature in the range of about 30°C to about 215°C when the film is formed thereon.

*FIG. 2*

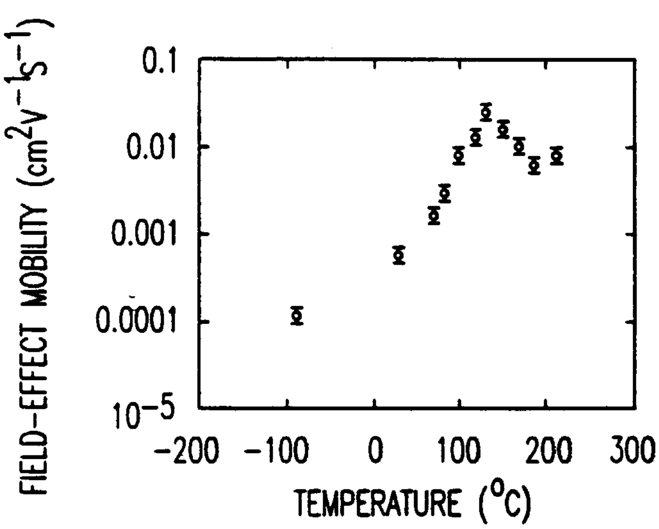


EP 0 921 579 A2

## Description

### Continuing Application Information

This application is a continuation-in-part of U.S. Serial No. 08/702,073 which was filed on August 23, 1996 and is hereby incorporated by reference.

### Field of the Invention

This invention relates to thin film transistors (TFTs) that contain an active layer of organic material, and to methods for making such transistors.

### Background of the Invention

Organic semiconductor materials are currently being investigated for use as the active layer in a variety of devices including light-emitting diodes, nonlinear optical devices, and TFTs such as metal-insulator-semiconductor field effect transistors (MIS-FETs). Organic semiconductor materials offer processing advantages such as compatibility with flexible plastic substrates and ease of application by spin-coating and their use in processes for device fabrication is therefore attractive. However, in order for these materials to be useful for use in TFT devices, the resulting devices must have an on/off ratio (of the source/drain current) suited for the particular application. Although devices with on/off ratios as low as 100 are suited for some application, typically TFT devices must have an on/off ratio of at least about $10^3$. The properties of the organic semiconductor materials that govern the on/off ratio are carrier mobility and conductivity. Organic semiconductor materials typically have a carrier mobility in excess of about $10^{-8}$ $cm^2/Vs$ but less than 1 $cm^2/Vs$. Consequently, based upon the relationship between carrier mobility, material conductivity, and device on/off ratio, the requisite conductivity of the organic semiconductor material is defined by the carrier mobility of the material and the desired on/off ratio.

A class of doped amorphous organic semiconductors is described in Brown, A.R., et al., "A universal relation between conductivity and field-effect mobility in doped amorphous organic semiconductors," Synthetic Materials, Vol. 68, pp. 65-70 (1994). Brown et al. report a linear relationship between the conductivity and the field effect mobility of such material, i.e., as the conductivity increases so does the field-effect mobility. Although Brown et al. report materials with a very high mobility, this high mobility was achieved at the expense of conductivity. Brown et al. conclude that high on/off ratios and high mobilities are not to be expected in devices constructed from amorphous organic semiconductors. Accordingly, if satisfactory devices are to be made from these materials, the field effect mobility and the conductivity of these materials must be within a range that provides a device with an on/off ratio of at least $10^5$.

### SUMMARY OF THE INVENTION

The present invention is directed to semiconductor devices with substituted organic semiconductor materials. These organic semiconductor materials are coordination compounds of substituted phthalocyanine (referred to herein with the abbreviation Pc) with copper, zinc, tin, iron or hydrogen. These coordination compounds form ordered films, and exhibit higher field effect mobility at lower conductivities than amorphous, doped phthalocyanine. At least one of the six-membered rings of the coordination compound has at least one chlorine or fluorine substituent thereon. It is advantageous if the six-membered rings are completely substituted with either fluorine or chlorine atoms. The embodiment of the present invention in which the six-membered rings are completely substituted is illustrated by the following structure:

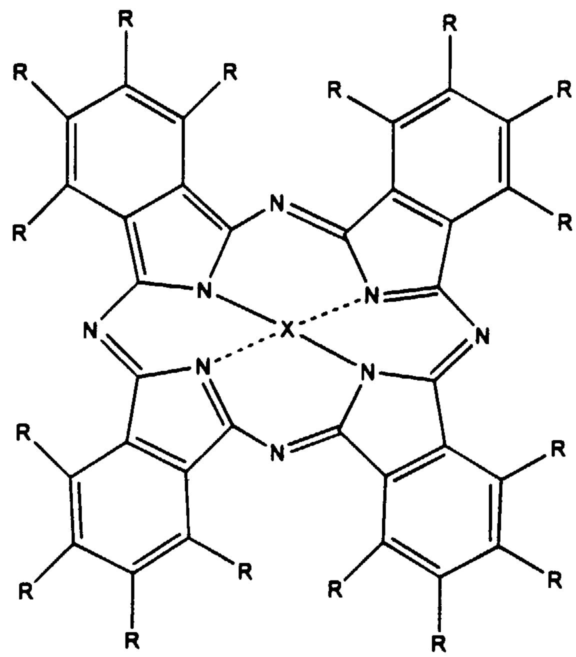

wherein X is either a metal atom such as copper, zinc, or iron and R is either chlorine or fluorine. The present invention is also directed to a process for making thin film devices with the organic thin film material.

In one embodiment, the present invention is directed to a semiconductor TFT device in which the active layer is an organic semiconductor material with a field effect mobility greater than $10^{-3}$ $cm^2/V$-s and a conductivity in the range of about $10^{-9}$ S/cm to about $10^{-7}$ S/cm. In one embodiment of the present invention, the device is a MIS-FET type TFT with an active layer of the organic semiconductor. Such devices typically have three spaced-apart contacts (e.g. conductive metals such as gold), at least two of which are in physical contact with the semiconductor layer. The third contact is adapted to control the current through the semiconductor layer between the first and second contacts.

The TFT device of the present invention is formed on a conventional substrate material such as glass, silicon or plastic. A layer of dielectric material is formed over the substrate. One of the contacts is physically connected to the substrate and the layer of dielectric material is interposed between the other two contacts and the substrate.

In another embodiment of the present invention, device is a light emitting diode (LED) wherein the electron transport layer is the substituted organic semiconductor material. In another embodiment of the present invention, the device is a solar cell. The solar cell has a p-n junction which consists of two material layers. The n layer is the electron transporting substituted organic semiconductor material of the present invention.

In the process of the present invention, the layer of phthalocyanine coordination compound is formed on a heated substrate. When the phthalocyanine coordination compound is formed on a heated substrate, device performance is improved. Specifically, when the temperature of the substrate is in the range of about 30°C to about 215°C, when the layer of phthalocyanine is formed thereon, the mobility of the resulting devices is greater than a like device in which the layer of phthalocyanine is formed on an unheated substrate. The temperature range in which advantageous mobility is observed depends on the metal coordinate in the phthalocyanine coordination compound. For example, if the metal coordinate is copper, advantageous mobility is observed throughout the range of about 30°C to about 215°C. If the metal coordinate is zinc, advantageous mobility is observed if the substrate temperature is about 125°C to about 215°C. If the metal coordinate is iron, advantageous mobility is observed if the temperature of the substrate is about 100°C to about 215°C.

The substituted phthalocyanine coordination compounds of the present invention are n-channel materials (i.e. electrons are transported through these materials). Therefore, these materials are used in devices that require n-channel materials. Such devices include Complementary MIS-FETs and Bipolar devices, which have both n-channel and p-channel devices on the same substrate. Another exemplary device is the n-channel MIS-FET. The n-channel materials of the present invention are also useful in light-emitting diodes (LED) and solar cells.

## BRIEF DESCRIPTION OF THE DRAWINGS

FIG. 1 is a cut away side view of a TFT device of the present invention.

FIG. 2 illustrates the relationship between the field effect mobility of a Cu-Pc film and the temperature of the substrate on which the film is formed.

FIG. 3 illustrates the relationship between the drain-source current and the drain-source voltage of a thin film device with a fluorine-substituted copper phthalocyanine semiconductor film at various gate voltages.

## DETAILED DESCRIPTION

The present invention is directed to semiconductor devices in which the active layer is a substituted phthalocyanine coordination compound and a process for making the device. The devices of the present invention are equipped with contacts for the application of current through the active layer. The substituted phthalocyanine coordination compound has four six-membered rings, at least one of which is substituted with a strong electron withdrawing group such as chlorine or fluorine. It is advantageous if all four of the six-membered rings in the coordination compound are completely substituted with the electron withdrawing groups. The embodiment of the present invention in which all of the six-membered rings are completely substituted is illustrated by the following structure:

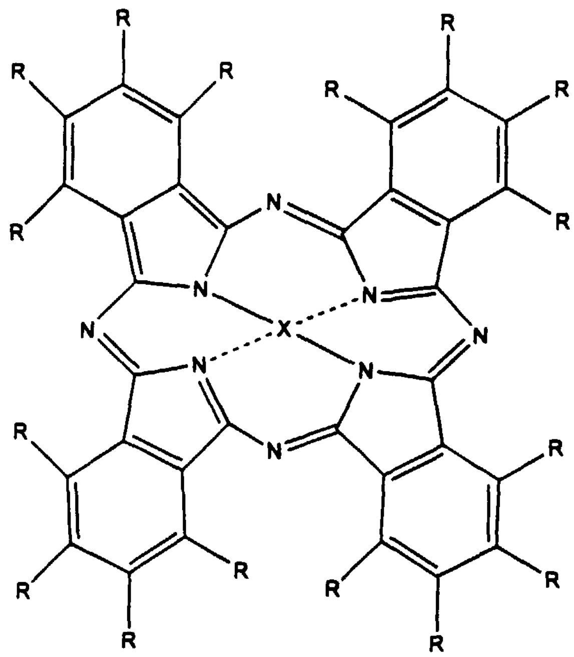

The coordinate ion is indicated generally by the letter X. It is advantageous if the coordinate ion is either copper, zinc, or iron.

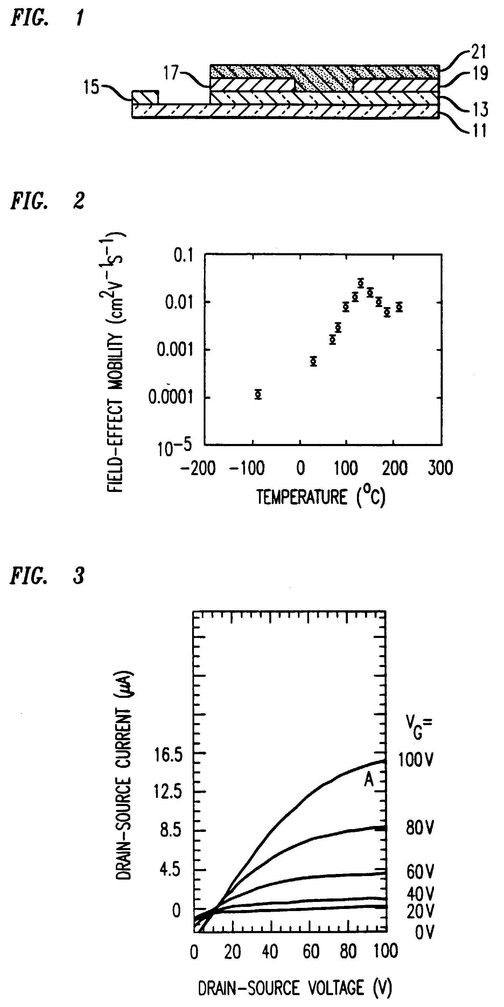

In one embodiment of the present invention the device is an n-channel TFT device. The device of the present invention has an on/off ratio greater than $10^3$ at 20°C. In order to obtain devices with the desired on/off ratio, it is advantageous if the phthalocyanine has a field effect mobility greater than $10^{-3}$ $cm^2/V$-s and a conductivity in the range of about $10^{-9}$ S/cm to about $10^{-7}$ S/cm. FIG. 1 illustrates one example of a MIS-FET type device according to the invention. The transistor 20 is a substrate 11 over which a layer of dielectric material 13 and a metal contact 15 are formed. Two additional metal contacts, 17 and 19, are formed over the dielectric layer 13. A layer of the phthalocyanine coordination compound 21 is formed over and between the contacts 17 and 19. One skilled in the art is aware that the transistor of the present invention is formed in a variety of different structures which are not detailed herein.

The substrate of the above-described device is made of conventional materials such as silicon, glass, or plastic. The contacts are made of a conventional material for this purpose such as gold. The dielectric material is a conventional material such as silicon dioxide, silicon nitride ($Si_3N_4$), or aluminum oxide ($Al_2O_3$). The contacts and the dielectric layer are formed on the substrate using well known, conventional techniques which are not discussed in detail herein.

By way of example, MIS-FET type TFTs are formed with a 12 μm channel length and a 250 μm gate length on

an n-doped silicon substrate. A 3000 Å thick layer of silicon dioxide is formed over the substrate. The silicon dioxide layer functions as a gate dielectric material and has a capacitance of about 10 $nF/cm^2$. Two separate gold contacts are formed over the gate dielectric layer. A film of a phthalocyanine coordination compound is formed over the gate dielectric layer and the contacts formed thereon. The phthalocyanine film is formed on a heated substrate. The temperature of the substrate is in the range of about 30° to about 215°C. As previously mentioned, the substrate temperature range in which an advantageous mobility of the resulting device is observed depends upon the metal coordinate in the phthalocyanine coordination compound. For example, an advantageous mobility is observed throughout the entire temperature range of about 30°C to about 215°C when the metal coordinate is copper. However, an advantageous mobility is observed through the temperature range of about 100°C to about 215°C when the metal coordinate is iron.

The phthalocyanine film is formed on the substrate using conventional techniques such as vacuum deposition. It is advantageous if the thickness of the phthalocyanine film is about 30 nm to about 100 nm. TFTs so formed have an on/off ratio greater than $10^4$ at 20°C.

In another embodiment of the present invention, the device is a light emitting diode (LED) wherein the electron transport layer is the substituted organic semiconductor material. One example on a suitable LED would be a glass substrate or a transparent plastic substrate on which a conventional anode such as an ITO electrode is formed. Over the anode is formed a hole transport layer. Examples of suitable materials for the hole transport layer include copper phthalocyanine, aromatic diamines, polyvinylcarbazole, and polyphenylene vinylene. Suitable thicknesses for these layers are in the range of about 30 nm to about 100 nm. An emitter layer is formed over the hole transported layer. Conventional emitter materials are contemplated as suitable and are selected base upon the desired color of the LED. The thickness of the emitter layer is on the order of about 10 nm or less. The electron transport layer is formed over the emitter layer. The electron transport layer has a thickness in the range of about 5 nm to about 20 nm. A cathode is formed over the electron transport layer. The cathode has a thickness of at least about 40 nm. Suitable materials for the cathode include, by way of example, aluminum and calcium.

In alternative embodiments, a separate emitter layer is not present. In these embodiments either the hole transport layer or the electron transport layer is doped with the emitter material, or the hole transport material is also a light-emitting material.

In another embodiment of the present invention, the device is a solar cell. The solar cell has a p-n junction which consists of two material layers. The n layer is the electron transporting substituted organic semiconductor material of the present invention. One example on a suitable solar cell is a glass substrate or a transparent plastic substrate on which a conventional electrode such as an ITO electrode is formed. Over the electrode is formed the substituted phthalocyanine n-channel semiconductor material. A layer of a p-channel semiconductor material is formed over the n-channel semiconductor layer. Examples of suitable p-channel materials include metalloporphyrins, quinacridone pigments, polyacetylene, and polypyrrole. Both the n-channel layer and the p-channel layer have a thickness of about 10 nm to about 1 µm. A conventional metal (e.g. gold, silver, aluminum, and indium) electrode is formed over the p-channel layer.

**Example 1**

Phthalocyanine coordination compounds with platinum (Pt), copper (Cu), zinc (Zn), nickel (Ni), iron (Fe), tin (Sn), and hydrogen ($H_2$) were obtained from a commercial supplier. For convenience, the phthalocyanine coordination compound is referred to generally as X-Pc, where X is a generic designation for the coordination ion (e.g., Pt, Fe, $H_2$, etc.) These materials were then purified by sublimation at a pressure of less than about 8 x $10^{-4}$ Torr and a temperature of about 380°C. This sublimation procedure was performed three times total.

Devices were formed using the above identified phthalocyanine coordination compounds as the active layer. A layer of phthalocyanine coordination compound 21 was formed on a substrate to form the device 20 depicted in FIG. 2 and described generally above. In the context of this example, the term substrate is used to refer to the structure of a silicon substrate 11 on which is formed a layer of gate dielectric 13 with two contacts 17 and 19 formed thereon. A third contact 15 is formed directly on the silicon substrate.

The temperature of the substrate was controlled during the deposition of each film thereon to determine the effect of substrate temperature on the mobility and conductivity of the phthalocyanine layer. Individual films of each of the above-identified phthalocyanine coordination compounds were formed on substrates heated to temperatures of 30°C, 125°C, and 200°C. Each film was formed using vacuum deposition in an evaporation chamber at a pressure of 2 x $10^{-6}$ torr. About 50 mg of the phthalocyanine was placed in a tungsten boat. The boat was placed in a conventional evaporator system. The substrate was also placed in the evaporator on a copper block. A temperature controller was used to control the temperature of the copper block which, in turn, was used to control the temperature of the substrate. The boat was heated to a temperature of about 380°C and the phthalocyanine film was formed at a rate of about 4 Å to about 5 Å per second.

The field-effect mobility and the conductivity of the various films prepared as described above is enumerated

in Table I below. The effect of the substrate temperature during film formation on the field-effect mobility and conductivity of the films is also reported in Table I.

TABLE I

| Material | Property | Substrate Temperature | | |
|---|---|---|---|---|
| | | 30°C | 125°C | 200°C |
| Cu-Pc | Mobility ($cm^2/Vs$) | $6.0 \times 10^{-4}$ | $2 \times 10^{-2}$ | $6.7 \times 10^{-3}$ |
| | Conductivity (S/cm) | $1.8 \times 10^{-9}$ | $4 \times 10^{-9}$ | $3.1 \times 10^{-9}$ |
| | on/off ratio | $3.7 \times 10^{4}$ | $4 \times 10^{5}$ | $1.7 \times 10^{5}$ |
| Zn-Pc | mobility ($cm^2/Vs$) | $2.3 \times 10^{-4}$ | $2.4 \times 10^{-3}$ | $2.8 \times 10^{-3}$ |
| | conductivity (S/cm) | $1.4 \times 10^{-6}$ | $1.1 \times 10^{-8}$ | $1 \times 10^{-7}$ |
| | on/off ratio | 12 | $2.2 \times 10^{4}$ | $2 \times 10^{3}$ |
| $H_2$-Pc | mobility ($cm^2/Vs$) | $1.3 \times 10^{-3}$ | $2.6 \times 10^{-3}$ | $5.6 \times 10^{-7}$ |
| | conductivity (S/cm) | $6.4 \times 10^{-7}$ | $2.2 \times 10^{-9}$ | $2.1 \times 10^{-9}$ |
| | on/off ratio | 160 | $8.1 \times 10^{4}$ | 26 |
| Sn-Pc | mobility ($cm^2/Vs$) | $7.3 \times 10^{-5}$ | $3.4 \times 10^{-3}$ | not measurable |
| | conductivity (S/cm) | $1.9 \times 10^{-7}$ | $2.4 \times 10^{-8}$ | $4.8 \times 10^{-8}$ |
| | on/off ratio | 36 | $1.6 \times 10^{4}$ | not measurable |
| Fe-Pc | mobility ($cm^2/Vs$) | $3.6 \times 10^{-5}$ | $6.9 \times 10^{-4}$ | $1.1 \times 10^{-5}$ |
| | conductivity (S/cm) | $5.1 \times 10^{-9}$ | $6.8 \times 10^{-7}$ | $1 \times 10^{-7}$ |
| | on/off ratio | 570 | 110 | 100 |
| Pt-Pc | mobility ($cm^2/Vs$) | $1.5 \times 10^{-4}$ | $1.5 \times 10^{-4}$ | $9 \times 10^{-5}$ |
| | conductivity (S/cm) | $2.2 \times 10^{-7}$ | $2.7 \times 10^{-7}$ | $4.7 \times 10^{-9}$ |
| | on/off ratio | 120 | 80 | $2.6 \times 10^{3}$ |
| Ni-Pc | mobility ($cm^2/Vs$) | $7 \times 10^{-6}$ | $3 \times 10^{-5}$ | $5.4 \times 10^{-5}$ |
| | conductivity (S/cm) | $3.9 \times 10^{-9}$ | $6.2 \times 10^{-8}$ | $6.4 \times 10^{-9}$ |
| | on/off ratio | 120 | 110 | 110 |

The field-effect mobility reported in Table I was calculated using the following equation:

$$I_{DS}=(WC_i/2L)\mu(V_G-V_O)^2$$

where W is the channel width (250 $\mu$m), L is the channel length (12 $\mu$m) and $C_i$ is the capacitance per unit area of the gate dielectric (10 $nF/cm^2$). To calculate the field effect mobility, $\mu$, using the above-identified equation, the threshold voltage ($V_O$) of the device is determined from the relationship between the square root of the drain-source current ($I_{DS}$) at the saturated region and the gate voltage of the device ($V_G$) by extrapolating from the measured values back to $I_{DS}$=0. The $I_{DS}$ at the saturated region is determined by observing the relationship between the drain-source voltage ($V_{DS}$) and the drain-source current at a given $V_G$. $I_{DS}$ at the saturated region is where $I_{DS}$ no longer increases with increasing drain-source voltage. $I_{DS}$ at the saturated region varies with $V_G$. This method for determining $V_O$ is conventional and well known to one skilled in the art.

The field effect mobilities reported in Table I are average values. Devices were formed using two substrates for every material and every temperature reported in Table I. For example, devices with a Cu-Pc film were formed on six substrates total, two at each of the reported temperatures. At least twenty devices were formed on each substrate.

The on/off ratio is the ratio of the drain current ($I_{D1}$) flowing in saturation when $V_G$ is equal to or greater than the drain voltage ($V_D$) to the $I_{D2}$ flowing when $V_G$ is zero. For example, if $I_{DS}$ is $8 \times 10^{-5}$ A when $V_D$ and $V_G$ are both -100 V and $I_{DS}$ is $1 \times 10^{-11}$ A when $V_G$ = 0 and $V_D$ -100 V, then the on/off ratio of the device is $8 \times 10^{6}$.

Although the inventor does not wish to be held to a particular theory, it is believed that the performance of the device is linked to the morphology of the phthalocyanine films. X-ray diffraction analysis of the films enumerated in Table I shows an increase in order in most of the films (i.e. the films became less amorphous) with an increase in the temperature of the substrate on which the films were formed. The order of the films was determined from the x-ray diffraction trace that results from the (200) lattice planes. A trace with a single peak was indicative of a highly ordered film. The intensity of this peak was observed to increase with an increase in the temperature of the substrate on which the film was formed.

Consequently, it appears that the order of the film is related to the field effect mobility of the material. As observed by the data in Table I, the field effect mobility of most films increased as the temperature of the substrate was increased from 30° to 125°C. As noted above, the order of the film also increased with increasing substrate temperature during film formation. However, Table I also shows a decrease in field effect mobility as the substrate temperature during deposition was increased from 125° to 200°C. This effect may be explained by the fact that film discontinuities increase at higher temperatures and these discontinuities have a negative effect on field effect mobility.

The relationship between the temperature of the substrate during film formation and the field effect mobility of a Cu-Pc film is illustrated in FIG. 2. FIG. 2 demonstrates that the field effect mobility of the Cu-Pc film increases dramatically as the temperature of the substrate increases from about 30°C to about 140°C. At substrate temperatures above 140°C, the trend reverses and the field effect mobility decreases with increasing temperature.

The substituted phthalocyanines of the present invention are n-type semiconductors (i.e. the materials transport electrons). The materials are also stable in air. In the context of the present invention, stable in air means that the electron transport properties of the semiconductor material do not degrade substantially over time in an air-containing atmosphere.

**Example 2**

The following compounds were purchased form the Aldrich Chemical company: $F_{16}CuPc$; $F_{16}ZnPc$; $F_{16}CoPc$; and $Cl_{16}FePc$. Cyanide-substituted copper phthalocyanine ($(CN)_8CuPc$) was synthesized according to the procedure described in Whorle, D., et al., Makromol. Chem., Vol. 181, p. 2127 (1980). Copper tetra-2,3-pyrazinoporphyrazine (PyCuPc) (pyrazin derivatized copper phthalocyanine) was prepared according to the procedure described in Schlettwein, D., et al., J. Electrochem. Soc., Vol. 136, p. 2882 (1989). These materials were then purified by sublimation twice at a pressure of less than about 8 x $10^{-4}$ Torr and a temperature of about 380°C. The structure of Copper tetra-2,3-pyrazinoporphyrazine is

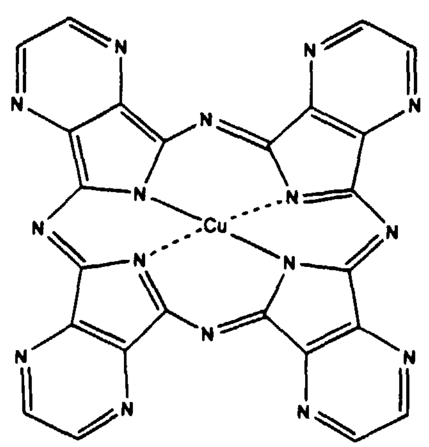

Devices were formed using the above identified phthalocyanine coordination compounds as the active layer. A layer of each of the above-described phthalocyanine coordination compounds 21 was applied onto a separate n-doped silicon substrate to form the device 20 depicted in FIG. 2 and described generally above. In the context of this example, the term substrate is used to refer to the structure of a silicon substrate 11 on which is formed a layer of gate dielectric 13 with two contacts 17 and 19 formed thereon. A third contact 15 is formed directly on the silicon substrate. The dielectric layer was 300 nm thick and had a capacitance ($C_i$) per unit area of 10 nF/$cm^2$. The contacts were gold contacts. Devices were made having channel length of 25 μm, 12 μm, 4 μm, and 1.5 μm.

The temperature of the substrate was controlled during the deposition of each film thereon to determine the effect of substrate temperature on the mobility and conductivity of the phthalocyanine layer. Individual films of each of

the above-identified substituted phthalocyanines coordination compounds were formed on substrates heated to temperatures of 30°C, 125°C, and 215°C. Each film was formed using vacuum deposition in an evaporation chamber at a pressure of 2 x $10^{-6}$ torr. About 50 mg of the phthalocyanine was placed in a tungsten boat. The boat was placed in a conventional evaporator system. The substrate was also placed in the evaporator on a copper block. A temperature controller was used to control the temperature of the copper block which, in turn, was used to control the temperature of the substrate. The boat was heated to a temperature of about 380°C and the phthalocyanine film was formed at a rate of about 0.4 nm to about 0.5 nm per second.

The electrical characteristics of these devices were measured under vacuum unless otherwise specified. The current-voltage characteristics were obtained using a Hewlett-Packard (HP) 4145B analyzer. The field effect mobility of the substituted phthalocyanine coordination compounds were calculated using the method described in Example 1 above. The calculated field effect mobilities for these devices is summarized in Table 2 below.

TABLE II

| Material | Mobility ($cm^2$/Vs) at Substrate Temperature | | |
|---|---|---|---|
| | 30°C | 125°C | 215°C |
| $F_{16}CuPc$ | 5 x $10^{-3}$ | 3 x $10^{-2}$ | 2 x $10^{-2}$ |
| $F_{16}ZnPc$ | 1.7 x $10^{-5}$ | 4.6 x $10^{-4}$ | 1.2 x $10^{-3}$ |
| $F_{16}$ CoPc | 1.8 x $10^{-6}$ | 4.5 x $10^{-5}$ | 4.3 x $10^{-5}$ |
| $F_{16}FePc$ | 5.5 x $10^{-4}$ | 5.8 x $10^{-3}$ | 1.3 x $10^{-3}$ |
| $Cl_{16}FePc$ | no field effect mobility was observed | 2.7 x $10^{-5}$ | Compound desorbed at this temperature |
| $(CN)_8CuPc$ | Compound cannot be sublimed | Compound cannot be sublimed | Compound cannot be sublimed |
| PyCuPc | Compound cannot be sublimed | Compound cannot be sublimed | Compound cannot be sublimed |

The mobility of the devices clearly increased when the deposition temperature increased from 30°C to 125°C. Decreases in mobilities for some devices were observed when the deposition temperature was increased above about 150°C, however. Although applicants do not wish to be held to a particular theory, applicants believe that the substituted phthalocyanine films formed at elevated temperature have an advantageous morphology for electron transport. However, the relationship between substrate temperature and the mobility of the resulting device depends somewhat on the metal coordinate in the substituted phthalocyanine coordination compound. For example, an advantageous mobility was observed throughout the entire temperature range of about 30°C to about 215°C when the metal coordinate was copper. However, an advantageous mobility was observed through the temperature range of about 100°C to about 215°C when the metal coordinate was iron. An advantageous mobility was observed through the temperature range of about 125°C to about 215°C when the metal coordinate was zinc.

Of the measured field-effect mobilities reported in Table II, the measured mobilities of the fluorinated phthalocyanines were the highest. The cyano-substituted phthalocyanine and the pyrazin derivatized copper materials decomposed before they could be sublimed onto the substrate.

The halogen-substituted phthalocyanines were observed to be stable in air. The electron mobility and the on/off ratio of devices with halogen-substituted phthalocyanine semiconductors did not change substantially even after the devices were stored in open air for more than six months. However, the devices formed with the chlorine-substituted phthalocyanine material at 30°C did not demonstrate measurable field-effect mobility and the chlorine-substituted material desorbed (i.e., the films did not form) at 215°C. Therefore, it appears that the fluorine-substituted phthalocyanine materials can be deposited under a wider range of conditions than the chlorine-substituted phthalocyanine materials.

FIG. 3 is a current-voltage curve obtained for a device with a $F_{16}CuPc$ semiconductor deposited on the substrate at a temperature of 125°C. The drain-source current (μA) is reported as a function of the drain-source voltage (V) at various gate voltages. The measured device had a channel length of 12 μm. The film as deposited performs as an n-channel transistor. As the gate voltage that was applied to the device was increased, an increased injection of electrons into the semiconductor film (indicated by an increase in drain-source current with an increase in drain-source voltage) was observed. From the data reported in FIG. 3 the field effect mobility of this device was calculated to be 0.03 $cm^2$/V-s using the method described in Example 1 above.

## Claims

1. A semiconductor device comprising:

   a substrate with a layer of a substituted phthalocyanine coordination compound formed thereon and contacts for applying current through the layer of the substituted phthalocyanine coordination compound wherein the phthalocyanine coordination compound has the following structure:

   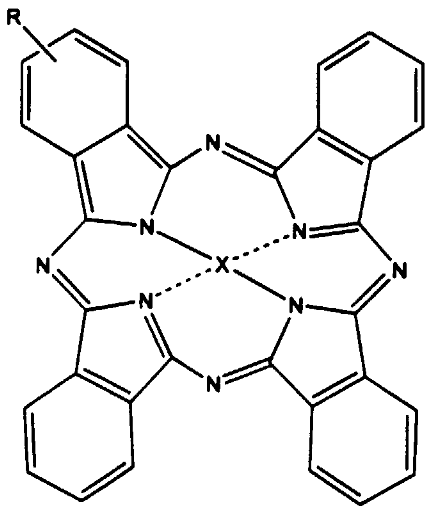

   wherein X is selected from the group consisting of copper, iron, and zinc and R is an electron-withdrawing substituent, and wherein at least one of the six-membered rings has at least one R substituent.

2. The semiconductor device of claim 1 wherein R is selected from the group consisting of fluorine and chlorine.

3. The semiconductor device of claim 1 wherein the semiconductor device is a thin film transistor and wherein the substituted phthalocyanine coordination compound has a field effect mobility greater than about $10^{-3}$ $cm^2/Vs$ and a conductivity in the range of about $10^{-9}$ S/cm to about $10^{-7}$ S/cm at 20°C and wherein the thin film transistor has an on/off ratio of the source-drain current that is at least about $10^3$.

4. The thin film transistor of claim 3 wherein the layer of substituted phthalocyanine coordination compound has a thickness of about 30 nm to about 100 nm.

5. The thin film transistor of claim 4 wherein the layer of substituted phthalocyanine coordination compound is an ordered layer.

6. The thin film transistor of claim 5 wherein the thin film transistor is an n-channel MIS-FET.

7. The semiconductor device of claim 2 wherein the six-membered rings are fully substituted with the electron withdrawing group.

8. The semiconductor device of claim 2 wherein the semiconductor device is a light emitting diode.

9. The semiconductor device of claim 2 wherein the semiconductor device is a solar cell.

*FIG. 1*

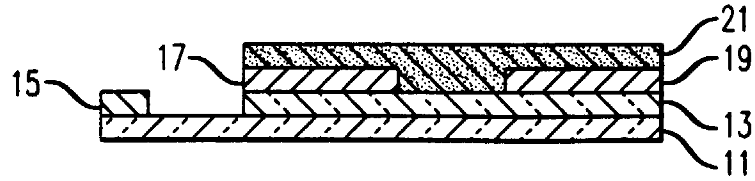


*FIG. 2*

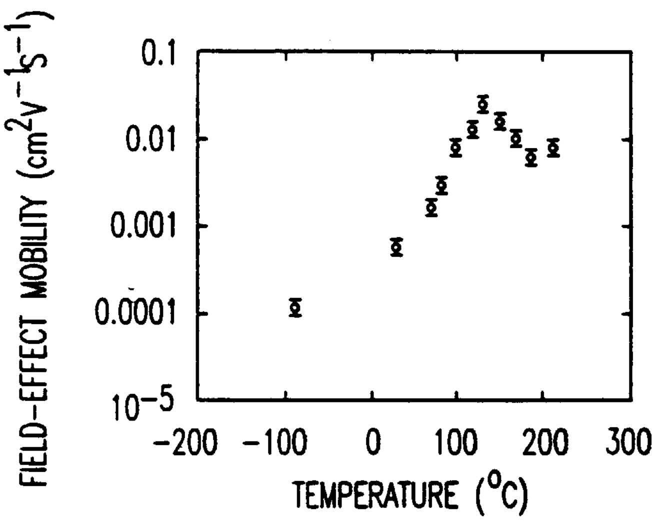


*FIG. 3*